# EUROPEAN PATENT APPLICATION

(11) **EP 2 434 547 A2**
(43) Date of publication of application: **28.03.2012**
(21) Application number: 11180653.5
(22) Date of filing: 09.09.2011
(51) Int. Cl.: H01L 29/778, H01L 21/335

(54) **Gallium nitride based semiconductor devices and methods of manufacturing the same**

(30) Priority: 28.09.2010 KR 20100093808
(71) Applicant: Samsung LED Co., Ltd., Gyunggi-do (KR)
(72) Inventor: Lee, Jae-hoon, Gyeonggi-do (KR)
(74) Representative: Grünecker, Kinkeldey, Stockmair & Schwanhäusser

(57) **Abstract**

Gallium nitride (GaN) based semiconductor devices and methods of manufacturing the same. The GaN-based semiconductor device may include a conductive heat dissipation substrate (that is, a thermal conductive substrate); an GaN-based multi-layer arranged on the heat dissipation substrate; and a Schottky electrode arranged on the GaN-based multi-layer. While such a GaN-based semiconductor device is being manufactured, a wafer bonding process and a laser lift-off process may be used.

## Description

### BACKGROUND

### 1. Field

The present disclosure relates to semiconductor devices and methods of manufacturing the same, and more particularly, to gallium nitride based semiconductor devices and methods of manufacturing the same.

### 2. Description of the Related Art

Recently, along with rapid developments in information and communication technologies, technologies for high-speed and massive-capacity signal transmission are being rapidly developed. In this regard, with an increasing demand for personal mobile phones, satellite communications, military radars, broadcasting communications, and communication relay devices, there has been an increasing request for high-speed and high-power electronic devices which are required for high-speed telecommunication systems using microwave and millimetric wave bands. Power devices for controlling relatively high levels of power are used for various purposes in many fields including communication fields, and various types of research are being conducted thereon.

A gallium nitride (GaN) based semiconductor has excellent material properties, such as a large energy gap, high thermal and chemical stability, high electron saturation speed (∼3×10⁷cm/sec), etc. Furthermore, an electronic device employing a GaN-based semiconductor has various advantages, such as a high breakdown electric field (∼3×10⁶ V/cm), high maximum current density, stable operation characteristics at high temperatures, etc. Due to such material properties, a GaN-based semiconductor may be applied to not only an optical device, but also a high frequency and high power electronic device and a high power device.

However, since a GaN-based semiconductor device is generally formed on a sapphire substrate having relatively low thermal conductivity, a GaN-based semiconductor device does not have an excellent heat dissipation characteristic. Although a SiC substrate may be used instead of a sapphire substrate for an improved heat dissipation characteristic, a SiC substrate is relatively expensive (about 10 times more expensive than a sapphire substrate), and thus the overall cost for manufacturing a GaN-based semiconductor device increases. Furthermore, the GaN-based semiconductor device may have some problems due to dislocations in a GaN layer, wherein the dislocations may occur due to a difference between lattice constants of a substrate and GaN.

### SUMMARY

Example embodiments of the present invention provide gallium nitride base semiconductor devices which may have an excellent heat dissipation characteristic, include a little defect, and also have an improved current spreading characteristic.

Example embodiments of the present invention also provide methods of manufacturing the GaN-based semiconductor devices.

According to an aspect of the present invention, a gallium nitride (GaN) based semiconductor device includes a conductive substrate; an AIGaN layer arranged on the conductive substrate; a GaN layer arranged on the AIGaN layer; and an electrode layer arranged on the GaN layer, the electrode layer forms a Schottky contact with the GaN layer.

The substrate may include a material having higher thermal conductivity than a sapphire substrate.

The substrate may include at least one of Al-Si, Si, Cu, Ni, W, Al, Cr, and a combination thereof.

The substrate and the AlGaN layer may form an ohmic contact.

The AlGaN layer may be an AlₓGa₁₋ₓN layer (here, x may satisfy 0 < x ≤ 0.6 or 0.1 ≤ x ≤ 0.5).

The AlGaN layer may be a layer doped with an n-type impurity.

The GaN layer may have a single layer structure or a multi layer structure.

The GaN layer may include at least one of an undoped GaN layer and an n-doped GaN layer.

The GaN layer may include a first GaN layer contacting the electrode layer and a second GaN layer arranged between the first GaN layer and the AlGaN layer. In this case, the first GaN layer may be an undoped layer or an n-doped layer, and the second GaN layer may be doped with at least one of Si and Al.

The AlGaN layer and the GaN layer may have N-face polarity.

The GaN-based semiconductor device may further include a superlattice structure layer between the substrate and the electrode layer.

The GaN layer may have a multi layer structure, and the superlattice structure layer may be arranged between a plurality of layers constituting the GaN layer.

The GaN-based semiconductor device may further include a blocking layer pattern arranged in the GaN layer.

According to another aspect of the present invention, a method of forming a gallium nitride (GaN) based semiconductor device, the method includes forming a GaN layer on a first substrate; forming an AlGaN layer on the GaN layer; providing a second substrate on the AlGaN layer; removing the first substrate to expose the GaN layer; and forming an electrode layer on the exposed portion of the GaN layer, the electrode layer forms a Schottky contact with the GaN layer.

The first substrate may be a sapphire substrate.

The GaN layer may be formed to have a single layer structure or a multi layer structure.

The GaN layer may include at least one of an undoped GaN layer and an n-doped GaN layer.

The step of forming of the GaN layer may include forming a first GaN layer on the first substrate; and forming a second GaN layer on the first GaN layer. In this case, the first GaN layer may be an undoped GaN layer or an n-doped GaN layer, and the second GaN layer may be doped with at least one of Si and Al.

The GaN layer may be formed to have a multi layer structure, and a superlattice structure layer may be formed between a plurality of layers constituting the GaN layer.

The AlGaN layer may be an AlₓGa₁₋ₓN layer (here, x may satisfy 0 < x ≤ 0.6 or 0.1 ≤ x ≤ 0.5).

The AlGaN layer may be an n-doped layer.

The second substrate may be a conductive substrate.

The second substrate may include a material having higher thermal conductivity than the first substrate.

The second substrate may include at least one of Al-Si, Si, Cu, Ni, W, Al, Cr, and a combination thereof.

The second substrate may be arranged on the AlGaN layer by using a bonding method or a plating method.

An ohmic contact layer may be formed between the AlGaN layer and the second substrate.

The step of removing of the first substrate may be performed by a laser lift-off method.

The method may further include forming a plurality of protrusions with pointed ends on the top surface of the first substrate; and forming a blocking layer pattern corresponding to the plurality of protrusions in the GaN layer.

The method may further include, after the step of removing the first substrate, partially removing the GaN layer.

### BRIEF DESCRIPTION OF THE DRAWINGS

The above and other features and advantages of the present invention will become more apparent by describing in detail exemplary embodiments thereof with reference to the attached drawings in which:
FIGS. 1 through 6 are sectional views of gallium nitride (GaN) based semiconductor device according to embodiments of the present invention;
FIGS. 7A through 7F are sectional views showing a method of manufacturing a GaN-based semiconductor device according to an embodiment of the present invention;
FIG. 8 is a sectional view showing a part of a method of manufacturing a GaN-based semiconductor device according to another embodiment of the present invention;
FIG. 9 is a sectional view showing a part of a method of manufacturing a GaN-based semiconductor device according to another embodiment of the present invention;
FIG. 10 is a sectional view showing a part of a method of manufacturing a GaN-based semiconductor device according to another embodiment of the present invention;
FIG. 11 is a sectional view showing a part of a method of manufacturing a GaN-based semiconductor device according to another embodiment of the present invention;
   and
FIGS. 12A and 12B are sectional views showing a method of manufacturing a GaN-based semiconductor device according to another embodiment of the present invention.

### DETAILED DESCRIPTION

Various example embodiments will now be described more fully with reference to the accompanying drawings in which exemplary embodiments are shown.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. As used herein the term "and/or" includes any and all combinations of one or more of the associated listed items.

It will be understood that, although the terms "first", "second", etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, a first element, component, region, layer or section discussed below could be termed a second element, component, region, layer or section without departing from the teachings of the exemplary embodiments.

Spatially relative terms, such as "beneath," "below," "lower," "above," "upper" and the like, may be used herein for ease of description to describe one element's or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

The terminology used herein is for the purpose of describing particular embodiments only and is not intended to be limiting of the exemplary embodiments. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

Exemplary embodiments are described herein with reference to cross-sectional illustrations that are schematic illustrations of idealized embodiments (and intermediate structures) of example embodiments. As such, variations from the shapes of the illustrations as a result, for example, of manufacturing techniques and/or tolerances, are to be expected. Thus, the exemplary embodiments should not be construed as limited to the particular shapes of regions illustrated herein but are to include deviations in shapes that result, for example, from manufacturing. For example, an implanted region illustrated as a rectangle will, typically, have rounded or curved features and/or a gradient of implant concentration at its edges rather than a binary change from an implanted to non-implanted region. Likewise, a buried region formed by implantation may result in some implantation in the region between the buried region and the surface through which the implantation takes place. Thus, the regions illustrated in the figures are schematic in nature and their shapes are not intended to illustrate the actual shape of a region of a device and are not intended to limit the scope of the exemplary embodiments.

Unless otherwise defined, all terms (including technical and scientific terms) used herein have the same meaning as commonly understood by one of ordinary skill in the art to which the exemplary embodiments belong. It will be further understood that terms, such as those defined in commonly-used dictionaries, should be interpreted as having a meaning that is consistent with their meaning in the context of the relevant art and will not be interpreted in an idealized or overly formal sense unless expressly so defined herein.

Hereinafter, gallium nitride (GaN) based semiconductor devices and methods of manufacturing the same, according to embodiments of the present invention, will be described in detail. In the drawings, the thicknesses of layers and regions are exaggerated for clarity. Like reference numerals in the drawings denote like elements, and thus their description will be omitted.

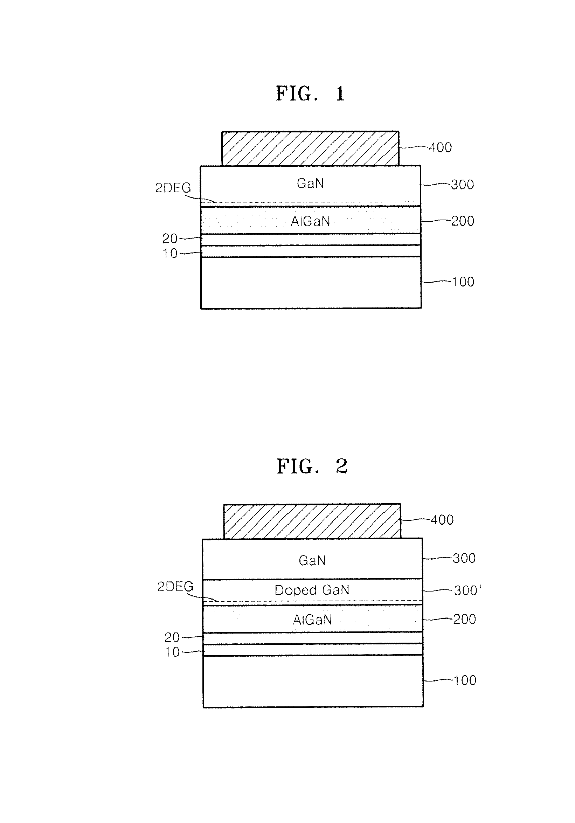

FIG. 1 shows a gallium nitride (GaN) based semiconductor device according to an embodiment of the present invention.

Referring to FIG. 1, an AlGaN layer 200 and a GaN layer 300 may be arranged on a heat dissipation substrate 100 in the order stated, and a Schottky electrode 400 may be arranged on the GaN layer 300. The heat dissipation substrate 100 may be a conductive substrate, and the AlGaN layer 200 may form an ohmic contact with the heat dissipation substrate 100. A bonding metal layer 10 and an ohmic metal layer 20 may be sequentially arranged between the heat dissipation substrate 100 and the AlGaN layer 200. A 2-dimensional electron gas layer (referred to hereinafter as a 2DEG layer) may exist near an interface of the GaN layer 300 contacting the AlGaN layer 200. The Schottky electrode 400 may form a Schottky contact with the GaN layer 300. Hereinafter, detailed description of each of the above components will be given.

The heat dissipation substrate 100 may be a conductive substrate and may be used as a bottom electrode. Furthermore, the heat dissipation substrate 100 may be a thermal conductive substrate having higher thermal conductivity than a sapphire substrate. For example, heat dissipation substrate 100 may be a substrate containing at least one of Al-Si, Si, Cu, Ni, W, Al, Cr, and a combination thereof. Such a heat dissipation substrate 100 may have a superior heat dissipation characteristic than a sapphire substrate, may be less expensive than a SiC substrate, and may be used as an electrode.

The AlGaN layer 200 arranged on the heat dissipation substrate 100 may be an AlₓGa₁₋ₓN layer (here, 0 < x ≤ 0.6 or 0.1 ≤ x ≤ 0.5). In other words, Al content in the AlGaN layer 200 may be less than or equal to 60 at%, and more particularly, from about 10 at% to about 50 at%. Furthermore, the AlGaN layer 200 may be a layer doped with an n-type impurity, that is, an n-doped layer. The n-type impurity may be Si, for example. The n-type impurity may be contained in the AlGaN layer 200 at a high concentration from about 10¹⁸ atom/cm³ to about 10²⁰ atom/cm³. Therefore, the AlGaN layer 200 may be an n+ layer. As the AlGaN layer 200 is doped with the n-type impurity, electric conductivity of the AlGaN layer 200 may increase, and ohmic contact characteristic with the heat dissipation substrate 100 may be improved. Thickness of the AlGaN layer 200 may be from about 10 nm to about 60 nm.

The GaN layer 300 formed on the AlGaN layer 200 may be either an undoped GaN layer or an n-doped GaN layer. If the GaN layer 300 is an n-doped GaN layer, concentration of an n-type impurity may be below about 10¹⁸ atom/cm³, e.g., about 10¹⁷ atom/cm³. Therefore, the GaN layer 300 may be an n- layer. Thickness of the GaN layer 300 may be from about 2 µm to about 10 µm.

In a heterojunction structure in which the AlGaN layer 200 and the GaN 300 are attached to each other, since band-discontinuity at a junction interface is large, electrons may be densely concentrated at the junction interface. Therefore, the 2DEG layer may be formed nearby the interface. Electron mobility in the 2DEG layer may be very high, and thus current spreading characteristic may be improved.

Furthermore, the AlGaN layer 200 and the GaN layer 300 may have N-face polarity. A GaN-based material layer having Wurzite structure may have N-face polarity in which N atoms are arranged on the topmost layer (an exposed surface) or Ga-face polarity in which Ga atoms are arranged on the topmost layer (an exposed surface). A GaN-based material layer having an N-face may have [000-1] directivity in the Z-axis direction, whereas a GaN-based material layer having a Ga-face may have [0001] directivity in the Z-axis direction. In a GaN-based heterojunction structure in which AlGaN and GaN are attached to each other, a location at which the 2DEG layer is to be formed may vary according to surface polarities of an AlGaN layer and a GaN layer. If GaN/AlGaN/GaN layers have N-face polarity, the 2DEG layer may be formed in the GaN layer disposed on the AlGaN layer. On the contrary, if the GaN/AlGaN/GaN layers have Ga-face polarity, the 2DEG layer may be formed in the GaN layer disposed under the AlGaN layer. As described above, according to surface polarity of a GaN-based material layer, characteristics and configurations of devices formed therefrom may vary. In the present embodiment, the AlGaN layer 200 and the GaN layer 300 have N-face polarity, and thus the 2DEG layer may be formed in the GaN layer 300 that is arranged on the AlGaN layer 200. If the GaN layer 300 has N-face polarity, characteristics of a semiconductor device (vertical type Schottky diode device) according to the present embodiment may be improved. In detail, if the GaN layer 300 has N-face polarity, potential barrier height with respect to the Schottky electrode 400, that is, Schottky barrier height may be increased. In other words, if the GaN layer 300 has N-face polarity, Schottky barrier height with respect to the Schottky electrode 400 formed thereon may be higher as compared to the case in which the GaN layer 300 has Ga-face polarity. Therefore, characteristics of a semiconductor device (vertical type Schottky diode device) according to the present embodiment may be improved by forming the GaN layer 300 to have N-face polarity.

The Schottky electrode 400 arranged on the GaN layer 300 may contain a metal or a conductive oxide that forms Schottky contact with the GaN layer 300. For example, the Schottky electrode 400 may have a single layer structure or a multi layer structure containing Ni, Au, Pt, CulnO₂, indium tin oxide (ITO), or the like. In more detail, the Schottky electrode 400 may have any of structures including Ni/Au, CulnO₂/Au, ITO/Au, Ni/Pt/Au, Pt/Au, etc. The materials stated above are mere examples, and any of various other conductive materials (metals, conductive oxides, etc.) may be applied to the Schottky electrode 400.

Meanwhile, the bonding metal layer 10 arranged between the heat dissipation substrate 100 and the AlGaN layer 200 may contain Au or AuSn, for example. The bonding metal layer 10 may be a layer provided to improve adhesiveness with respect to the heat dissipation substrate 100. However, if required, the bonding metal layer 10 may be used as a seed metal layer for forming the heat dissipation substrate 100. In this case, any of various metals aside from Au and AuSn may be applied to the bonding metal layer 10. The ohmic metal layer 20 arranged between the bonding metal layer 10 and the **AlGaN** layer 200 may have a single layer structure or a multi layer structure, containing at least one of Cr, Al, Ta, Ti, Au, and an alloy thereof. At least one of the bonding metal layer 10 and the ohmic metal layer 20 may be omitted.

A semiconductor device having a structure as described above may exhibit excellent heat dissipation and current spreading properties and may have improved Schottky junction characteristic. Furthermore, since the semiconductor device according to the present embodiment may have a vertical type structure in which the heat dissipation substrate 100 and the Schottky electrode 400 are used as electrodes (an anode and a cathode), a number of chips to be formed per a unit area may be increased as compared to a horizontal type device. Therefore, the semiconductor device according to the present embodiment may be advantageous for cost reduction.

According to another embodiment of the present invention, another GaN layer may be further arranged between the AlGaN layer 200 and the GaN layer 300 of FIG. 1. An example thereof is shown in FIG. 2.

Referring to FIG. 2, a second GaN layer 300' may be arranged between the AlGaN layer 200 and the GaN layer (referred to hereinafter as a first GaN layer) 300. Like the GaN layer 300 of FIG. 1, the first GaN layer 300 may be an undoped layer or an n-doped layer. The second GaN layer 300' may be a layer doped with at least one of Si and Al. For example, the second GaN layer 300' may be a layer doped with Al and Si at less than 1 at% each. Here, Si is an n-type impurity that may increase electric conductivity of the second GaN layer 300'. By being doped with Si, the second GaN layer 300' may become an n+ layer. Meanwhile, Al may not only improve crystallinity of the second GaN layer 300', but also contribute to increase of a number of carriers (electrons). Therefore, characteristics of the GaN-based semiconductor device may be improved by the second GaN layer 300' doped with at least one of Si and Al. As such, in the case where the second GaN layer 300' is arranged between the AlGaN layer 200 and the first GaN layer 300, the 2DEG layer may exist near an interface of the second GaN layer 300' contacting the AlGaN layer 200. Configuration of the GaN-based semiconductor device as shown in FIG. 2 other than the second GaN layer 300' may be identical to those shown in FIG. 1, and thus detailed descriptions thereof will be omitted.

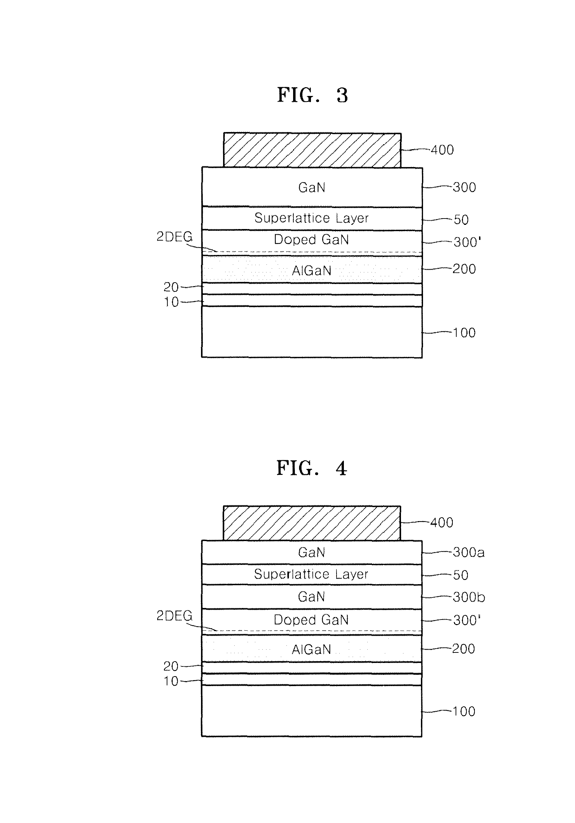

According to another embodiment of the present invention, a superlattice structure layer may be further arranged between the heat dissipation substrate 100 and the Schottky electrode 400. Examples thereof are shown in FIGS. 3 through 5.

Referring to FIG. 3, a superlattice structure layer 50 may be arranged between the first GaN layer 300 and the second GaN layer 300'.

Referring to FIG. 4, the first GaN layer 300 may be divided into a plurality of layers, e.g., two layers 300a and 300b, and the superlattice structure layer 50 may be arranged therebetween.

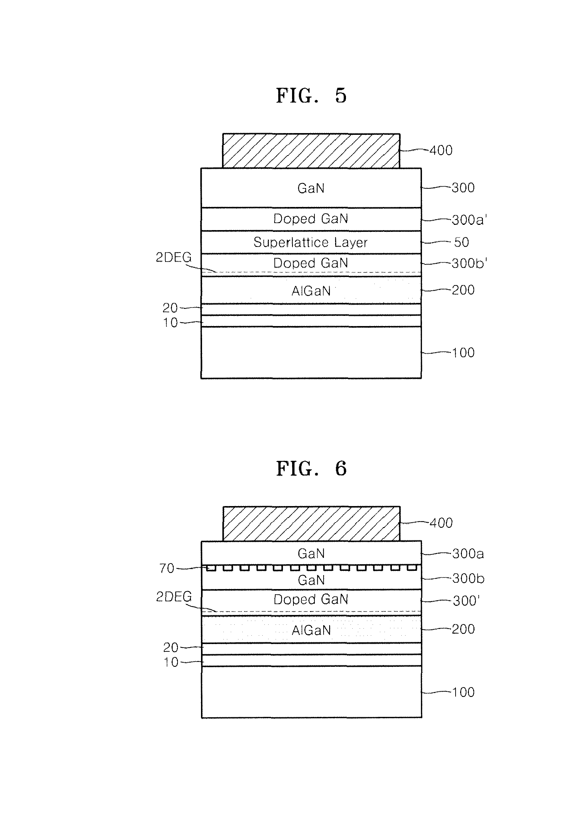

Referring to FIG. 5, the second GaN layer 300 may be divided into a plurality of layers, e.g., two layers 300a' and 300b', and the superlattice structure layer 50 may be arranged therebetween.

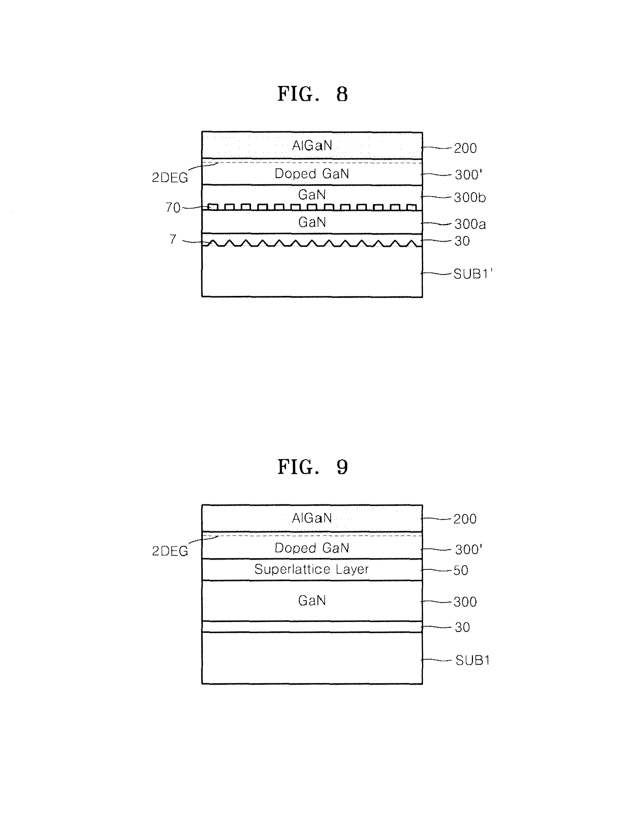

In FIGS. 3 through 5, the superlattice structure layer 50 may have a structure in which an AlGaN layer, a GaN layer, and an lnGaN layer are repeatedly stacked in the order stated, for example. In other words, the superlattice structure layer 50 may have a structure in which AlGaN/GaN/lnGaN structures are repeatedly stacked for n times. Here, n may be from about 5 to about 20. Structure of the superlattice structure layer 50 may vary. For example, unit structure to be repeatedly stacked may vary; e.g., AlGaN/GaN**,** GaN/lnGaN, AlN/GaN/lnN, AlN/GaN, GaN/lnN, etc. If required, the superlattice structure layer 50 may have a single layer structure instead of a multi layer structure. Dislocation that occurred in the first GaN layer 300 or the second GaN layer 300' may be bent by the superlattice structure layer 50. Detailed description thereof will be given below with reference to FIGS. 9 through 11.

Dislocation may act as a path for current leakage and adversely affecting characteristics of a GaN-based semiconductor device. Particularly, dislocation growing in a vertical direction in a vertical type semiconductor device may become more serious problem as compared to dislocation in a horizontal type semiconductor device. However, in the present embodiment, problems due to dislocation may be prevented or suppressed by eliminating (or reducing) dislocation by using the superlattice structure layer 50. According to another embodiment of the present invention, dislocation may be eliminated/prevented by using another means aside from the superlattice structure layer 50. In other words, another means aside from the superlattice structure layer 50 may be used to eliminate/prevent dislocation.

FIG. 6 shows a GaN-based semiconductor device according to another embodiment of the present invention.

Referring to FIG. 6, the first GaN layer 300 may be divided into a plurality of layers, e.g., the two layers 300a and 300b, and a blocking layer pattern 70 may be arranged therebetween. Cross-section of the blocking layer pattern 70 may have a rectangular shape or other shapes similar to the rectangular shape. The blocking layer pattern 70 may be formed of an insulator, such as silicon oxide or silicon nitride. The blocking layer pattern 70 may be a layer introduced during a manufacturing process to prevent growth (progression) of dislocation. Detailed description thereof will be given below with reference to FIG. 8. The blocking layer pattern 70 may not only prevent growth (progression) of dislocation, but also contribute to current spreading by spreading currents flowing through the GaN layers 300a and 300b in horizontal directions. Accordingly, current crowding may be reduced by the blocking layer pattern 70, and thus current spreading effect may be strengthened.

Modified embodiments shown in FIGS. 3 through 6 may be cumulatively applied to a single semiconductor device. For example, the superlattice structure layer 50 and the blocking layer pattern 70 may be applied together to a single semiconductor device.

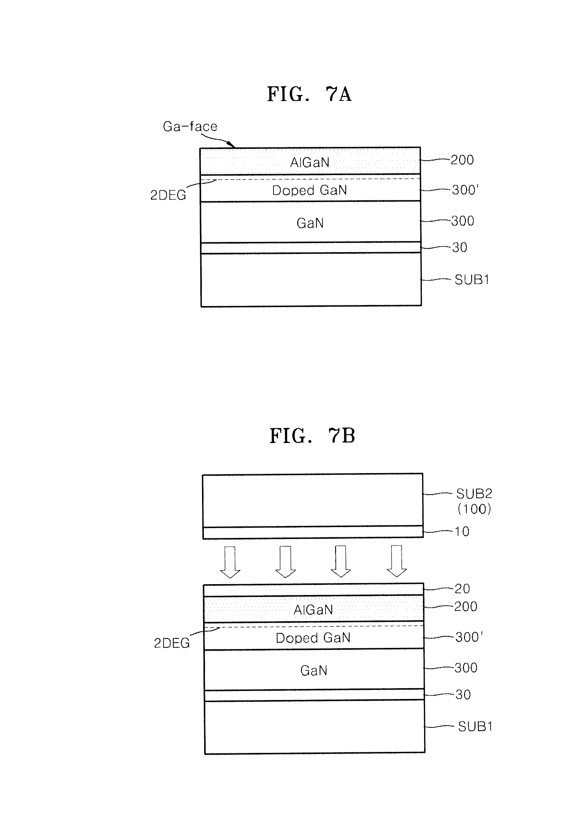

FIGS. 7A through 7F show a method of manufacturing a GaN-based semiconductor device according to an embodiment of the present invention.

Referring to FIGS. 7A, a first GaN layer 300 may be formed on a first substrate SUB1. The first substrate SUB1 may be, for example, a sapphire substrate. Since there is no substrate having a lattice constant and thermal expansion coefficient identical to those of a GaN-based material, a GaN-based material is generally grown on a sapphire substrate. Before the first GaN layer 300 is formed, a buffer layer 30 may be formed on the first substrate SUB1, and the first GaN layer 300 may be formed thereon. The buffer layer 30 may be arranged to increase crystallinity of the first GaN-based layer 300 by reducing differences in the lattice constants and the thermal expansion coefficients between the first substrate SUB1 and the first GaN layer 300. The buffer layer 30 may be formed of GaN or SiC, for example. The first GaN layer 300 may be either an undoped GaN layer or a GaN layer lightly doped with an n-type impurity. The first GaN layer 300 may have Ga-face polarity. The first GaN layer 300 may be formed to have a thickness from about 2 µm to about 10 µm.

A second GaN layer 300' may be formed on the first GaN layer 300. The second GaN layer 300' may be a GaN layer doped with at least one of Si and Al. For example, the GaN layer 300' may be a layer doped with Al and Si at less than 1 at% each. Here, Si is an n-type impurity that may increase electric conductivity of the second GaN layer 300'. By being doped with Si, the second GaN layer 300' may become an n+ layer. Meanwhile, Al may not only improve crystallinity of the second GaN layer 300', but also contribute to increase of a number of carriers (electrons).

An AlGaN layer 200 may be formed on the second GaN layer 300'. The AlGaN layer 200 may be formed of AlₓGa₁₋ₓN (here, 0 < x ≤0.6 or 0.1 ≤ x ≤ 0.5). In other words, Al content in the AlGaN layer 200 may be less than or equal to 60 at%, and more particularly, from about 10 at% to about 50 at%. Furthermore, the AlGaN layer 200 may be a layer doped with an n-type impurity, that is, an n-doped layer. The n-type impurity may be Si, for example. The n-type impurity may be contained in the AlGaN layer 200 at a high concentration from about 10¹⁸ atom/cm³ to about 10²⁰ atom/cm³. Therefore, the AlGaN layer 200 may be an n+ layer. As the AlGaN layer 200 is doped with the n-type impurity, electric conductivity of the AlGaN layer 200 may increase. Thickness of the AlGaN layer 200 may be from about 10 nm to about 60 nm.

Since the first GaN layer 300 has Ga-face polarity, the second GaN layer 300' and the AlGaN layer 200 formed thereon may also have Ga-face polarity. In this case, the 2DEG layer may exist near an interface of the second GaN layer 300' contacting the AlGaN layer 200.

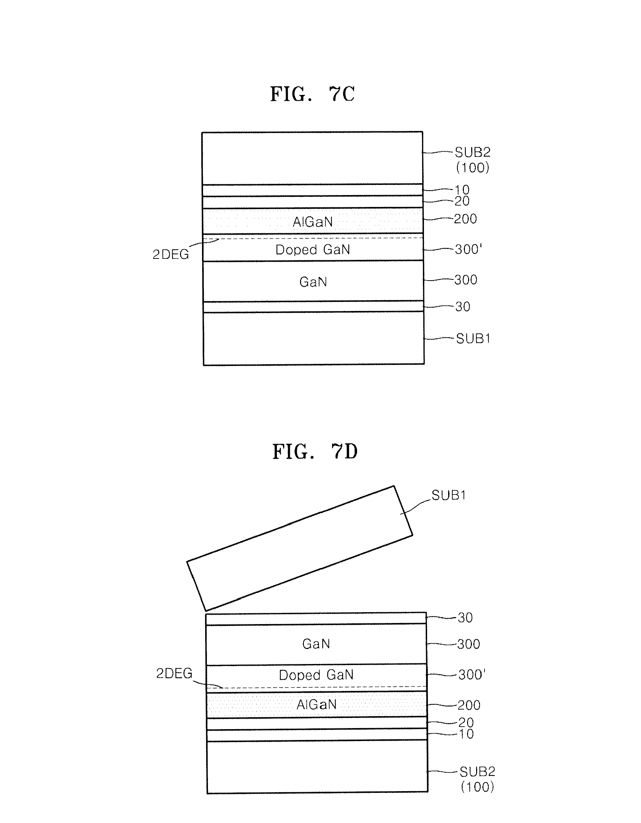

Referring to FIGS. 7B and 7C, a second substrate SUB2 may be attached to the top surface of the AlGaN layer 200. After a bonding metal layer 10 is formed on the bottom surface of the second substrate SUB2 and an ohmic metal layer 20 is formed on the top surface of the AlGaN layer 200, the second substrate SUB2 may be attached to the AlGaN layer 200 via the bonding metal layer 10 and the ohmic metal layer 20. Alternatively, after the bonding metal layer 10 is arranged on the top surface of the ohmic metal layer 20 instead of the bottom surface of the second substrate 20, the second substrate SUB2 may be attached to the AlGaN layer 200. Alternatively, after the ohmic metal layer 20 is arranged on the bottom surface of the bonding metal layer 10 instead of the top surface of the AlGaN layer 200, the second substrate SUB2 may be attached to the AlGaN layer 200. The bonding metal layer 10 may be formed of Au or AuSn, for example. The ohmic metal layer 20 may be formed to have a single layer structure or a multi layer structure, containing at least one of Cr, Al, Ta, Ti, Au, and an alloy thereof. At least one of the bonding metal layer 10 and the ohmic metal layer 20 may be omitted.

The second substrate SUB2 is a conductive substrate and may be used as an electrode. Furthermore, the second substrate SUB2 may be a thermal conductive substrate having higher thermal conductivity than the first substrate SUB1 (e.g., a sapphire substrate). For example, the second substrate SUB2 may be a substrate containing at least one of Al-Si, Si, Cu, Ni, W, Cr, and a combination thereof. Such a second substrate SUB2 may have a superior heat dissipation characteristic than the first substrate SUB1 (e.g., a sapphire substrate) and may be less expensive than a SiC substrate.

The second substrate SUB2 may be formed on the AlGaN layer 200 by using a plating method instead of a wafer bonding method. In this case, the bonding metal layer 10 may be a seed layer for forming the second substrate SUB2. Any of various seed materials used in general plating methods may be applied to the seed layer.

Referring to FIG. 7D, after the stacked structure including the first substrate SUB1 and the second substrate SUB2 is turned upside down, the first substrate SUB1 may be removed. The first substrate SUB1 may be removed by using a laser lift-off method, for example. Since the laser lift-off method is well-known in the art, a detailed description thereof will be omitted.

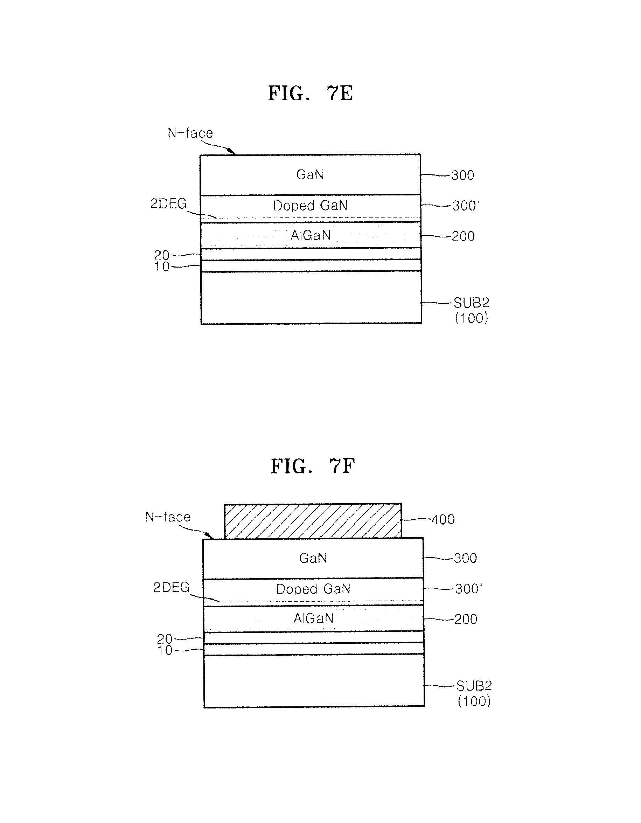

Next, the buffer layer 30 may be removed. A result thereof is shown in FIG. 7E.

The stacked structure including from the second substrate SUB2 to the first GaN layer 300 of FIG. 7E corresponds to the stack structure including from the first GaN layer 300 to the second substrate SUB2 of FIG. 7C that is turned upside down. Therefore, in FIG. 7E, it may be considered that the first GaN layer 300 has N-face polarity.

Referring to FIG. 7F, a Schottky electrode 400 may be formed on the top surface (N-face) of the first GaN layer 300. The Schottky electrode 400 may contain a metal or a conductive oxide that forms Schottky contact with the first GaN layer 300. For example, the Schottky electrode 400 may have a single layer structure or a multi layer structure containing Ni, Au, Pt, CulnO₂, indium tin oxide (ITO), or the like. In more detail, the Schottky electrode 400 may have any of structures including Ni/Au, CulnO₂/Au, ITO/Au, Ni/Pt/Au, Pt/Au, etc. The materials stated above are mere examples, and any of various other conductive materials (metals, conductive oxides, etc.) may be applied to the Schottky electrode 400. Since the first GaN layer 300 has N-face polarity, potential barrier height between the first GaN layer 300 and the Schottky electrode 400, that is, Schottky barrier height may be higher as compared to the case in which the first GaN layer 300 has Ga-face polarity.

According to the method as described above, a GaN-based semiconductor device (Schottky diode device), which exhibits excellent heat dissipation characteristic by being arranged on a heat dissipation substrate (that is, the second substrate SUB2), improved current spreading characteristic, and excellent Schottky junction characteristic, may be manufactured.

Various modifications may be made in the manufacturing method described above. Hereinafter, various modifications of the manufacturing method will be described with reference to FIGS. 8 through 11.

Referring to FIG. 8, a plurality of protrusions 7 with pointed ends may be formed on the top surface of a first substrate SUB1'. Cross-section of the protrusion 7 may have a triangular shape or other shapes similar to the triangular shape. When viewed from above, the plurality of protrusions 7 may be regularly arranged as a dotted pattern. The protrusions 7 and the first substrate SUB1' may be formed of a same material. Therefore, the protrusions 7 may be considered as a portion of the first substrate SUB1'. A blocking layer pattern 70 corresponding to the protrusions 7 may be arranged in the first GaN layers 300a and 300b. Cross-section of the blocking layer pattern 70 may have a rectangular shape or other shapes similar to the rectangular shape. The blocking layer pattern 70 may be formed of an insulator, such as silicon oxide or silicon nitride. After the blocking layer pattern 70 is formed, the GaN layer 300b may be formed thereon by using an epitaxial lateral overgrowth (ELOG) method. Next, a GaN-based semiconductor device may be manufactured via operations similar to those shown in FIGS. 7B through 7F.

In FIG. 8, the protrusions 7 may be a means for inducing dislocation. In other words, dislocation may be induced at end points of the protrusions 7. Growth of dislocation induced by the protrusions 7 may be prevented by the blocking layer pattern 70. Therefore, growth of dislocation may be suitably prevented by the blocking layer pattern 70. The blocking layer pattern 70 may also contribute to current spreading by spreading currents flowing through the first GaN layers 300a and 300b in horizontal directions.

Although not shown, during a later operation for removing the first substrate SUB1', e.g., a laser lift-off operation, the protrusions 7 may also be removed. The blocking layer pattern 70 may or may not remain in the final structure. In the case of the latter, the blocking layer pattern 70 may be removed with the GaN layer 300a after the first substrate SUB1' is removed.

The modified embodiments shown in FIGS. 9 through 11 are regarding the cases in which the superlattice structure layers 50 are provided.

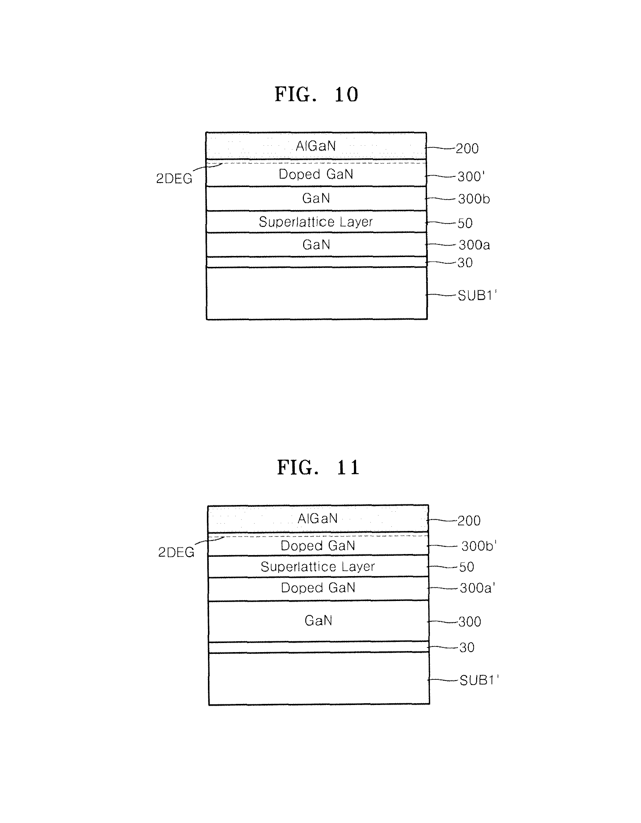

As shown in FIG. 9, the superlattice structure layer 50 may be formed between the first GaN layer 300 and the second GaN layer 300'. Alternatively, as shown in FIG. 10, the first GaN layer 300 may be divided into a plurality of layers, e.g., the two layers 300a and 300b, and the superlattice structure layer 50 may be formed therebetween. Alternatively, as shown in FIG. 11, the second GaN layer 300' may be divided into a plurality of layers, e.g., the two layers 300a' and 300b', and the superlattice structure layer 50 may be formed therebetween. Configuration of the superlattice structure layer 50 may be identical to that described above with reference to FIGS. 3 through 5, and thus detailed description thereof will be omitted. The superlattice structure layer 50 may bend dislocation growing from the first GaN layers 300 and 300a and/or the second GaN layers 300a' therebelow. Dislocation may occur due to insufficient reduction of difference between lattice constants of the first substrate SUB1 and the first GaN layers 300 and 300a via the buffer layer 30. Deterioration of characteristics of a GaN-based semiconductor device may be prevented by eliminating such a dislocation by using the superlattice structure layer 50. After the structures as shown in FIGS. 9 through 11 are formed, a GaN-based semiconductor device may be manufactured via operations similar to those shown in FIGS. 7B through 7F. The superlattice structure layers 50 of FIGS. 9 through 11 may also be applied to the manufacturing operation shown in FIG. 8.

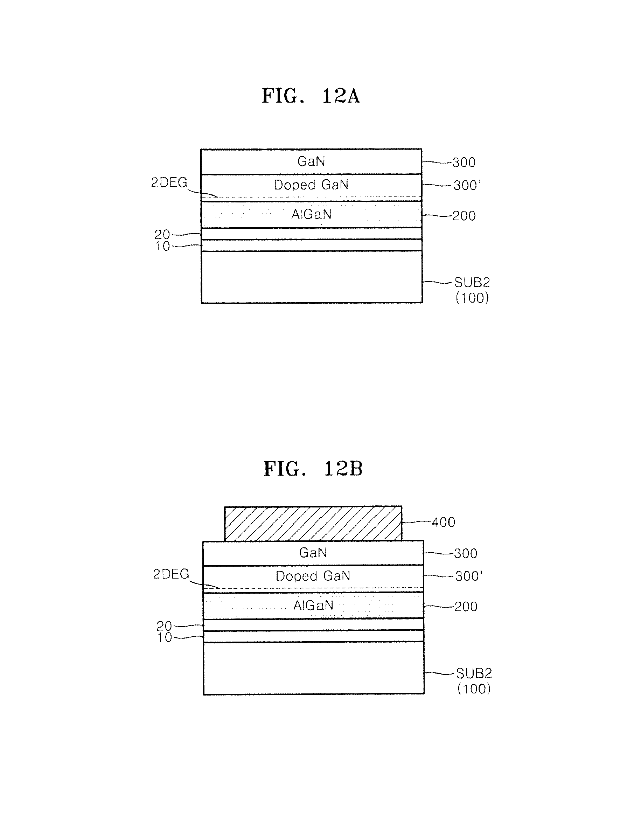

According to another embodiment of the present invention, after the first substrate SUB1 is removed in the operation shown in FIG. 7D, the buffer layer 30 may be removed, and then the first GaN layer 300 may be partially removed. A result thereof is shown in FIG. 12A. For partially removing the first GaN layer 300, a chemical mechanical polishing (CMP) operation, a dry etching operation, or a wet etching operation may be performed. Here, the thickness of a removed portion of the first GaN layer 300 may be less than or equal to several micrometers (µm). Next, as shown in FIG. 12B, the Schottky electrode 400 may be formed on the remaining first GaN layer 300.

Characteristics of a GaN-based semiconductor device may be improved by performing later manufacturing operations after partially removing the first GaN layer 300 as shown in FIGS. 12A and 12B. In detail, the first GaN layer 300 grown on the first substrate SUB1 in the operation shown in FIG. 7A may include a plurality of defects (e.g., dislocations) in the lower portion of the first GaN layer 300. The reason thereof may be insufficient reduction of difference between lattice constants of the first substrate SUB1 and the first GaN layers 300a via the buffer layer 30. By removing the portion (the lower portion in FIG. 7A, the upper portion in FIG. 7D) of the first GaN layer 300 including a plurality of defects (e.g., dislocations), characteristics of the GaN-based semiconductor device may be improved as a result. The method may be applied to the embodiments shown in FIGS. 8 through 11.

While the present invention has been particularly shown and described with reference to exemplary embodiments thereof, it will be understood by those of ordinary skill in the art that various changes in form and details may be made therein without departing from the spirit and scope of the present invention as defined by the following claims.

## Claims

1. A gallium nitride (GaN) based semiconductor device comprising:
a conductive substrate;
an AlGaN layer arranged on the conductive substrate;
a GaN layer arranged on the AlGaN layer; and
an electrode layer arranged on the GaN layer, the electrode layer forms a Schottky contact with the GaN layer.

2. The GaN-based semiconductor device of claim 1, wherein the substrate comprises a material having higher thermal conductivity than a sapphire substrate,
and optionally wherein the substrate comprises at least one of Al-Si, Si, Cu, Ni, W, Al, Cr, and a combination thereof.

3. The GaN-based semiconductor device of claim 1 or 2, wherein the substrate and the AlGaN layer form an ohmic contact.

4. The GaN-based semiconductor device of any preceding claim, wherein the AlGaN layer is an AlₓGa₁₋ₓN layer (here, 0 < x ≤ 0.6),
and optionally wherein the AlGaN layer is a layer doped with an n-type impurity.

5. The GaN-based semiconductor device of any preceding claim, wherein the GaN layer has a single layer structure or a multi layer structure,
and optionally wherein the GaN layer comprises at least one of an undoped GaN layer and an n-doped GaN layer.

6. The GaN-based semiconductor device of any preceding claim, wherein the GaN layer comprises a first GaN layer contacting the electrode layer and a second GaN layer arranged between the first GaN layer and the AlGaN layer,
the first GaN layer is an undoped layer or an n-doped layer, and
the second GaN layer is doped with at least one of Si and Al.

7. The GaN-based semiconductor device of any preceding claim, wherein the AlGaN layer and the GaN layer have N-face polarity.

8. The GaN-based semiconductor device of any preceding claim, further comprising:
a superlattice structure layer between the substrate and the electrode layer,
and/or
a blocking layer pattern arranged in the GaN layer.

9. A method of forming a gallium nitride (GaN) based semiconductor device, the method comprising:
forming a GaN layer on a first substrate;
forming an AlGaN layer on the GaN layer;
providing a second substrate on the AlGaN layer;
removing the first substrate to expose the GaN layer; and
forming an electrode layer on the exposed portion of the GaN layer, the electrode layer forms a Schottky contact with the GaN layer.

10. The method of claim 9, wherein the GaN layer is formed to have a single layer structure or a multi layer structure,
and optionally wherein the GaN layer comprises at least one of an undoped GaN layer and an n-doped GaN layer.

11. The method of claim 9 or 10, wherein the forming of the GaN layer comprises forming a first GaN layer on the first substrate; and forming a second GaN layer on the first GaN layer,
the first GaN layer is an undoped GaN layer or an n-doped GaN layer, and
the second GaN layer is doped with at least one of Si and Al.

12. The method of any of claims 9 to 11, wherein the AlGaN layer is an AlₓGa₁-ₓN layer (here, 0 < x ≤0.6),
and optionally wherein the AlGaN layer is an n-doped layer.

13. The method of any of claims 9 to 12, wherein the second substrate is a conductive substrate,
and optionally wherein the second substrate comprises a material having higher thermal conductivity than the first substrate,
and optionally wherein the second substrate comprises at least one of Al-Si, Si, Cu, Ni, W, Al, Cr, and a combination thereof.

14. The method of any of claims 9 to 13, wherein the removing of the first substrate is performed by a laser lift-off method.

15. The method of any of claims 9 to 14, further comprising, after the first substrate is removed, partially removing the GaN layer.
